# EUROPEAN PATENT APPLICATION

(11) **EP 4 517 816 A2**
(43) Date of publication of application: **05.03.2025**
(21) Application number: 24194987.4
(22) Date of filing: 16.08.2024
(51) Int. Cl.: H01L 23/48

(54) **SEMICONDUCTOR STRUCTURE AND METHOD FOR FORMING THE SAME**

(30) Priority: 30.08.2023 US 202363579529 P; 08.08.2024 US 202418797902
(71) Applicant: MediaTek Inc., 30078 Hsinchu City (TW)
(72) Inventor: HUANG, Cheng-Lin, 30078 Hsinchu City (TW); YANG, Ting-Li, 30078 Hsinchu City (TW)
(74) Representative: Haseltine Lake Kempner LLP

(57) **Abstract**

A semiconductor structure and a method for forming the same are provided. The semiconductor structure includes an interconnect structure, a passivation layer and a conductive bump structure. The interconnect structure includes a conductive pad located at a top of the interconnect structure. The passivation layer is disposed on the interconnect structure. The conductive bump structure is disposed on and embedded into the passivation layer and the conductive pad. In a first direction, a first interface between the passivation layer and the conductive pad is located beside and misaligned with a second interface between the conductive bump structure and the conductive pad.

## Description

This application claims the benefit of U.S. Provisional Application No. 63/579,529, filed August 30, 2023, the entirety of which is incorporated by reference herein.

### BACKGROUND OF THE INVENTION

### Field of the Invention

The present invention relates to a semiconductor structure and a method for forming the semiconductor structure, and, in particular, to a semiconductor structure whose bump structures have improved reliability and a method for forming the semiconductor structure.

### Description of the Related Art

In recent years, advanced integrated circuit (IC) devices have become increasingly multifunctional and have been scaled down in terms of size. Although the scaling-down process generally increases production efficiency and lowers associated costs, it has also increased the complexity of processing and manufacturing IC devices. For example, the need has arisen in the semiconductor manufacturing process to move to copper (Cu)-based interconnects integrated with low-k dielectrics in order to dramatically reduce chip resistivity (R) and capacitance (C). Copper has lower resistivity than Al-based alloys. Therefore, the semiconductor devices fabricated with Cu-based interconnects will show reduced resistance-capacitance (RC) delays. However, the copper oxidation rate is high when there is no self-passivation layer formed to prevent the underlying copper from further oxidation. The oxidation of Cu-based interconnects becomes be a serious concern in the reliability of the following bumping processes.

Thus, a novel semiconductor structure having an improved reliability is desirable.

### BRIEF SUMMARY OF THE INVENTION

An embodiment of the present invention provides a semiconductor structure. The semiconductor structure includes an interconnect structure, a passivation layer and a conductive bump structure. The interconnect structure includes a conductive pad located at a top of the interconnect structure. The passivation layer is disposed on the interconnect structure. The conductive bump structure is disposed on and embedded into the passivation layer and the conductive pad. In a first direction, a first interface between the passivation layer and the conductive pad is located beside and misaligned with a second interface between the conductive bump structure and the conductive pad.

In addition, an embodiment of the present invention provides a method for forming a semiconductor structure. The method includes forming an interconnect structure including a conductive pad located at the top of the interconnect structure. The method further includes forming a passivation layer on the interconnect structure. The method further includes forming a first opening passing through the passivation layer to expose the top surface of the conductive pad. The method further includes performing a surface treatment process to form a recess of the conductive pad recessed from the top surface of the conductive pad exposed from the first opening. The method further includes forming a conductive bump structure on the passivation layer, filling the first opening and the recess of the conductive pad. In a first direction, a first interface between the passivation layer and the conductive pad is located beside and misaligned with a second interface between the conductive bump structure and the conductive pad.

### BRIEF DESCRIPTION OF THE DRAWINGS

The present invention can be more fully understood by reading the subsequent detailed description and examples with references made to the accompanying drawings, wherein:
FIG. 1 is a schematic cross-sectional view of a semiconductor structure in accordance with some embodiments of the disclosure;
FIG. 2 is a partial enlarged view of FIG. 1;
FIG. 3 is a schematic cross-sectional view of a semiconductor structure in accordance with some embodiments of the disclosure;
FIG. 4 is a partial enlarged view of FIG. 3;
FIG. 5 is a schematic cross-sectional view of a semiconductor structure in accordance with some embodiments of the disclosure;
FIG. 6 is a partial enlarged view of FIG. 5;
FIG. 7 is a schematic cross-sectional view of a semiconductor structure in accordance with some embodiments of the disclosure;
FIG. 8 is a partial enlarged view of FIG. 7;
FIG. 9 is a schematic cross-sectional view of a semiconductor structure in accordance with some embodiments of the disclosure;
FIG. 10 is a partial enlarged view of FIG. 9;
FIG. 11 is a schematic cross-sectional view of a semiconductor structure in accordance with some embodiments of the disclosure;
FIG. 12 is a partial enlarged view of FIG. 11;
FIGS. 13, 14, 15, 16, 17 and 18 are schematic cross-sectional views of intermediate stages of forming the semiconductor structures of FIGS. 1 and 4 in accordance with some embodiments of the disclosure;
FIG. 19 is a schematic cross-sectional view of an intermediate stage of forming the semiconductor structures of FIGS. 3 and 9 in accordance with some embodiments of the disclosure; and
FIG. 20 is a schematic cross-sectional view of an intermediate stage of forming the semiconductor structures of FIGS. 5 and 11 in accordance with some embodiments of the disclosure.

### DETAILED DESCRIPTION OF THE INVENTION

The following description is made for the purpose of illustrating the general principles of the invention and should not be taken in a limiting sense. The scope of the invention is best determined by reference to the appended claims.

Copper (Cu) pads are widely adopted in the advanced semiconductor devices. Compared with the aluminum (Al) pads, the Cu pads have lower parasitic resistance-capacitance values (RC) for performance improvement. However, when the semiconductor wafers or dies is in the long queue storage before forming the bump structures, the oxidation of the Cu pads may impact the reliability of the bump structures, thereby affecting the manufacturing quality of the semiconductor devices. Thus, a novel semiconductor structure having improved reliability of the bump structures is desirable.

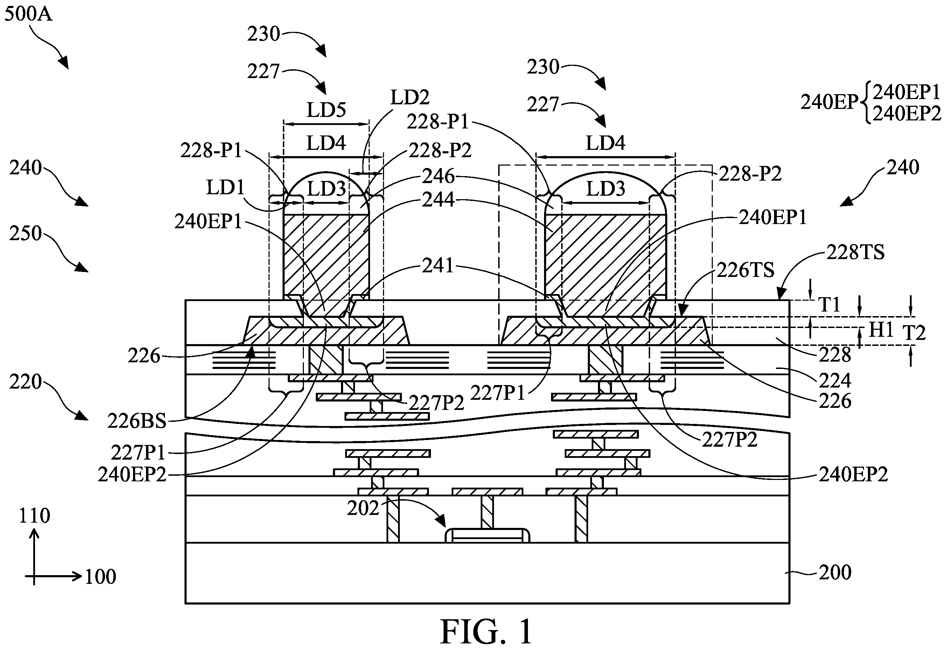

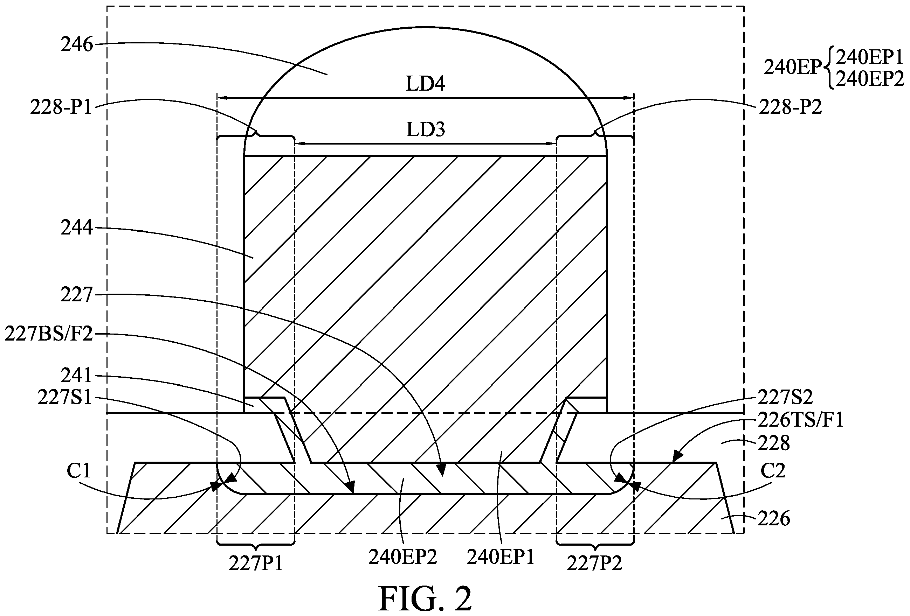

FIG. 1 is a schematic cross-sectional view of a semiconductor structure 500A in accordance with some embodiments of the disclosure. FIG. 2 is a partial enlarged view of FIG. 1. In some embodiments, the semiconductor structure 500A includes a semiconductor device using conductive bump structures connecting a base (not shown) such as a printed circuit board (PCB). The semiconductor structure 500A may include a semiconductor device 250 and a conductive bump structure 240 electrically coupled to the semiconductor device 250. In some embodiments, the semiconductor device includes a semiconductor die, a passive component, a package or a wafer level package. In some embodiments, the semiconductor device 250 may include a substrate 200, an interconnect structure 220, a first passivation layer 224 and a conductive pad 226. The semiconductor structure 500A may further include a second passivation layer 228 and a conductive bump structure 240 on the semiconductor device 250.

In some embodiments, the substrate 200 may include but is not limited to a semiconductor substrate. The substrate 200 may be provided for a circuit element 202 fabricated on the active surface of the substrate 200. In some embodiments, the circuit element 202 may include active devices, passive devices or other applicable devices. The interconnect structure 220 is formed on the substrate 200, covering the circuit element 202. In some embodiments, the interconnect structure 220 provides electrical transmitting paths for the circuit element 202. In some embodiments, the interconnect structure 220 includes a redistribution layer (RDL) structure having a plurality of metal layers, a plurality of dielectric layers alternately laminated with the metal layers and a plurality of vias formed through the dielectric layers on the substrate 200. For example, the dielectric layers of the interconnect structure 220 may be extra-low-k (ELK) dielectric layers. For example, the metal layers of the interconnect structure 220 may comprise but is not limited to copper or alloys thereof.

The first passivation layer 224 is disposed over the substrate 200. The first passivation layer 224 belongs to the uppermost dielectric layer of the interconnect structure 220 and provides protection to the underlying circuit element 202. In some embodiments, the first passivation layer 224 may include an organic or inorganic dielectric layer, such as silicon oxide, silicon nitride, silicon oxynitride, polybenzoxazole (PBO), benzocyclobutene (BCB), the like, or a combination thereof.

The conductive pad 226 is located at the top of the interconnect structure 220. The conductive pad 226 is disposed on the first passivation layer 224. In other words, the first passivation layer 224 is disposed underlying a bottom surface 226BS of the conductive pad 226. In addition, the conductive pad 226 belongs to the uppermost metal layer of the interconnect structure 220. In addition, a top surface 226TS of the conductive pad 226 may be a flat surface. In some embodiments, the conductive pad 226 is used to transmit input/output (I/O), ground or power signals of the semiconductor device 250. In some embodiments, the conductive pad 226 may include copper (Cu) or alloys thereof.

In some embodiments, the conductive pad 226 has a recess 227 recessed from the top surface 226TS of the conductive pad 226. The recess 227 may be located at the center of the conductive pad 226. As shown in FIG.1, the recess 227 has a bottom surface 227BS and opposite side surfaces 227S1, 227S2. The bottom surface 227BS of the recess 227 is surrounded by the top surface 226TS of the conductive pad 226. In addition, the side surfaces 227S1 and 227S2 are both connected between the top surface 226TS of the conductive pad 226 and the bottom surface 227BS of the recess 227.

In some embodiments, a depth H1 of the recess 227 is between about 0.02 µm and 3 µm that is relative to a thickness T2 of the conductive pad 226 between about 1.5 µm and 3 µm in the direction 110 that is substantially perpendicular to the top surface 226TS of the conductive pad 226. In some embodiments, a ratio of the thickness T2 of the conductive pad 226 to the depth H1 of the recess 227 (i.e., T2/H1) is between 1 and 75.

In some embodiments, the bottom surface 227BS of the recess 227 includes a flat surface or a concave surface. As shown in FIG. 1, a corner Cl between the side surface 227S1 and the bottom surface 227BS and a corner C2 between the side surface 227S2 and the bottom surface 227BS of the recess 227 may include a sharp corner or a rounded corner.

The second passivation layer 228 is disposed on the top of the interconnect structure 220. The second passivation layer 228 may cover the first passivation layer 224 and a portion of the conductive pad 226. The second passivation layer 228 may provide protection to the underlying conductive pad 226. In addition, the top surface 228TS of the second passivation layer 228 may be a flat surface.

In some embodiments, the second passivation layer 228 has an opening 230. The opening 230 is located directly on the recess 227 of the conductive pad 226 to define the formation position of the subsequent conductive bump structure 240. In addition, the opening 230 is formed passing through the second passivation layer 228 to expose the recess 227 of the conductive pad 226.

In some embodiments as shown in FIG. 1, a portion of the recess 227 of the conductive pad 226 may be exposed from the opening 230 of the second passivation layer 228. That is to say, the recess 227 of the conductive pad 226 may undercut a portion of the second passivation layer 228 above the top surface 226TS of the conductive pad 226. In this embodiment, the second passivation layer 228 includes opposite protruding portions 228-P1 and 228-P2 above the top surface 226TS of the conductive pad 226. The protruding portion 228-P1 may protrude from the top surface 226TS and extend in the direction 100 to be positioned over the corresponding side surface 227S1 and a portion of the bottom surface 227BS of the recess 227. The protruding portion 228-P1 may overhang the recess 227. In addition, the protruding portion 228-P2 may protrude from the top surface 226TS and extend in the direction 100 to be positioned over the corresponding side surface 227S2 and a portion of the bottom surface 227BS of the recess 227. The protruding portion 228-P1 may overhang the recess 227. As shown in FIG. 1, the protruding portion 228-P1, the corresponding side surface 227S1 and a portion of the bottom surface 227BS of the recess 227 overlapping the protruding portion 228-P1 may form a lateral portion 227P1 of the recess 227. In addition, the protruding portion 228-P2, the corresponding side surface 227S2 and a portion of the bottom surface 227BS of the recess 227 overlapping the protruding portion 228-P2 may form a lateral portion 227P2 of the recess 227. The remaining portion of the recess 227 except for the lateral portions 227P1 and 227P2 may serve as a vertical portion of the recess 227.

In some embodiments, if the recess 227 does not include the lateral portions 227P1 and 227P2, the whole recess 227 of the conductive pad 226 may be exposed from the opening 230 of the second passivation layer 228. The side surfaces 227S1 and 227S2 may be aligned with opposite sidewalls of the opening 230.

As shown in FIGS. 1 and 2, the lateral portions 227P1 and 227P2 of the recess 227 extends in the direction 100 (i.e., the lateral direction). In some embodiments, the lateral portions 227P1 and 227P2 of the recess 227 have a rounded shape, a polygonal shape, a scallop shape, a strip shape, or an irregular shape in a cross-sectional view as shown in FIG. 1.

In some embodiments, a dimension LD1 of the protruding portion 228-P1 and a dimension LD2 of the protruding portion 228-P2 in the direction 100 are both between 0.01 µm and 3µm. If the dimension LD1 (or the dimension LD2) is greater than 3um, a seed layer (e.g., a seed layer of the under bump metallurgy (UBM) layer 241) of the subsequent conductive bump structure 240 formed lining the lateral portion 227P2 of the recess 227 by the deposition process including physical vapor deposition (PVD) may be formed as a discontinuous layer. In addition, the micro-voids may be formed at very inner site of the lateral portion 227P2 of the recess 227 after filling the conductive bump structure 240 in the space the deposition process including electroless plating. The discontinuous seed layer and /or the micro-voids may be an initial crack source and will propagate to the interface causing delamination after long term electrical stressing and impact the reliability of the resulting semiconductor structure 500A. In some embodiments, a ratio of the dimension LD1 to the dimension LD2 (i.e., LD1/LD2) is between 0.03 and 3, or vice versa.

In some embodiments, the second passivation layer 228 may be a multilayer structure including silicon oxide, silicon nitride, silicon oxynitride, polybenzoxazole (PBO), benzocyclobutene (BCB), the like, or a combination thereof.

The conductive bump structure 240 is disposed on the second passivation layer 228 and the conductive pad 226. In addition, the conductive bump structure 240 is formed passing through the opening 230 and connected to the conductive pad 226. As shown in FIG. 1, the conductive bump structure 240 is embedded into the second passivation layer 228 and the conductive pad 226. The conductive bump structure 240 may be in contact with the bottom surface 227BS and the opposite side surfaces 227S1, 227S2 of the recess 270 of the conductive pad 226. In addition, the conductive bump structure 240 may fill the lateral portion 227P1 and 227P2 of the recess 227. In some embodiments, the conductive bump structure 240 may be mushroom-shaped or hourglass-shaped in the cross-sectional view as shown in FIGS. 1 and 2.

In some embodiments, in the direction 100, an interface Fl between the second passivation layer 228 and the conductive pad 226 is located beside and misaligned with an interface F2 between the conductive bump structure 240 and the conductive pad 226. For example, the interface Fl may be located at the top surface 226TS of the conductive pad 226. In addition, the interface F2 may be located at the bottom surface 227BS of the recess 227 of the conductive pad 226.

As shown in FIG. 1, a distance between the interface Fl and the interface F2 in the direction 110 may be the same as the depth H1 of the recess 227. Therefore, in the direction 110, a ratio of the thickness T2 of the conductive pad 226 to the distance H1 between the interface Fl and the interface F2 (i.e., T2/H1) may be between 1 and 75.

In some embodiments, the conductive bump structure 240 has an embedded portion 240EP embedding into the second passivation layer 228 and the conductive pad 226. In addition, the embedded portion 240EP may be adjacent to the protruding portions 228-P1 and 228-P2 of the second passivation layer 228. In some embodiments, the embedded portion 240EP of the conductive bump structure 240 has a pillar shape, an inverted hammer shape or an anchor-like shape in a cross-sectional view. For example, as shown in FIG. 1, the embedded portion 240EP of the conductive bump structure 240 may have an inverted hammer shape or an anchor-like shape.

In some embodiments, the embedded portion 240EP of the conductive bump structure 240 includes sub-portions 240EP1 and 240EP2. The sub-portion 240EP1 may be formed embedded into the second passivation layer 228. The sub-portion 240EP2 may be formed embedded into the conductive pad 226. In the direction 100, the sub-portion 240EP1 may have a dimension LD3, the sub-portion 240EP2 may have a dimension LD4. In some embodiments, the dimension LD3 is equal to a dimension of the opening 230 of the second passivation layer 228. The dimension LD4 is greater than or equal to the dimension LD3. In addition, a portion of the conductive bump structure 240 protruding from the top surface 228TS of the second passivation layer 228 may have a dimension LD5 that is greater than or equal to the dimension LD3. In some embodiments, the sub-portion 240EP1 may serve as a narrow neck portion of the conductive bump structure 240.

In some embodiments, the conductive bump structure 240 includes a microbump, a copper pillar bump, a controlled collapse chip connection (C4) bump, the like, or a combination thereof. For example, the conductive bump structure 240 may include the under bump metallurgy (UBM) layer 241 located on the conductive pad 226, a conductive pillar 244 located on the under bump metallurgy (UBM) layer 241, and a solder cap 246 located on the conductive pillar 244.

As shown in FIG. 1, the under bump metallurgy (UBM) layer 241 of the conductive bump structure 240 is formed passing through and the opening 230 of the second passivation layer 228 and overlying the conductive pad 226. The under bump metallurgy (UBM) layer 241 may line the opening 230 of the second passivation layer 228 and fill the recess 227 in the conductive pad 226. The under bump metallurgy (UBM) layer 241 may also extend onto the top surface 228TS of the second passivation layer 228. In some embodiments, the under bump metallurgy (UBM) layer 241 includes a seed layer (not shown), such as a pure copper (Cu) layer, a pure titanium (Ti) layer, a Ti/Cu layer, a TiW/Cu layer, any other metal layer, and combinations thereof. In some other embodiments, the seed layer of the under bump metallurgy (UBM) layer 241 includes a titanium nitride (TiN) layer, a tantalum (Ta) layer, or a tantalum nitride (TaN) layer, a silver (Ag) layer, a gold (Au) layer, an aluminum (Al) layer, and combinations thereof. In some other embodiments, the under bump metallurgy (UBM) layer 241 include a nickel (Ni) layer is formed on the seed layer. In some embodiments, the under bump metallurgy (UBM) layer 241 is formed by a deposition method includes a physical vapor deposition (PVD), such as a sputtering or plating method.

The conductive pillar 244 of the conductive bump structure 240 is formed on the under bump metallurgy (UBM) layer 241 and fills the opening 230 of the second passivation layer 228, as shown in FIG. 1 in accordance with some embodiments of the disclosure. In addition, a dimension of a portion of the conductive pillar 244 above the second passivation layer 228 may be the same as the dimension LD5. In some embodiments, the conductive pillar 244 and the seed layer of the under bump metallurgy (UBM) layer 241 may include the same material, such as copper (Cu). In some embodiments, the conductive pillar 244 is formed by a photolithography process and a subsequent electroplating process.

The solder cap 246 is formed on conductive pillar 244 by a solder plating process or a screen printing process, a photoresist stripping process, and a solder reflow process.

In some embodiments, the embedded portion 240EP includes the under bump metallurgy (UBM) layer 241 and the conductive pillar 244. As shown in FIG. 1, the sub-portion 240EP1 may be formed of the under bump metallurgy (UBM) layer 241 and the conductive pillar 244. In addition, the sub-portion 240EP2 may be formed of the under bump metallurgy (UBM) layer 241.

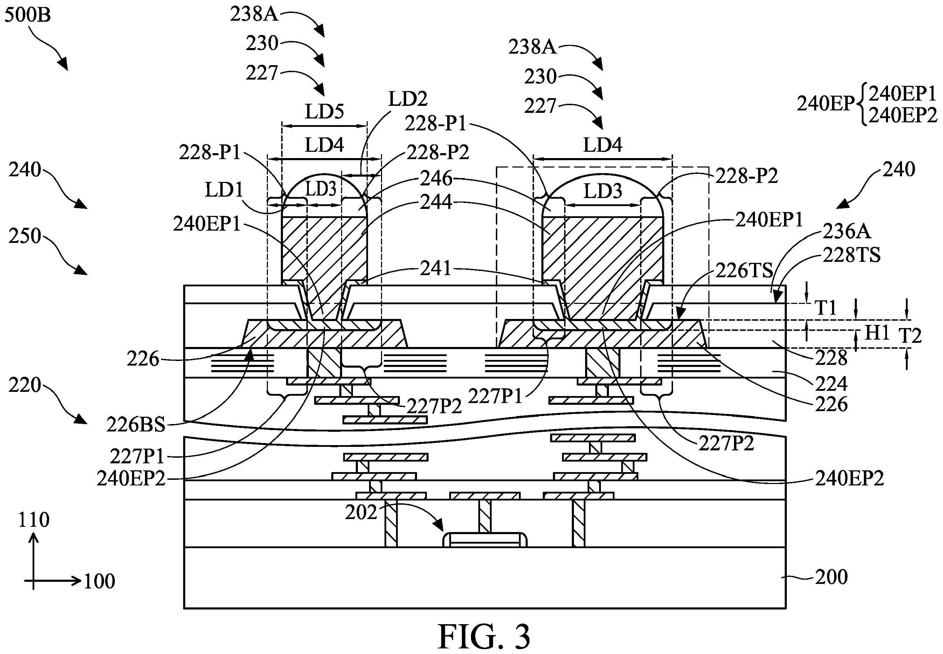

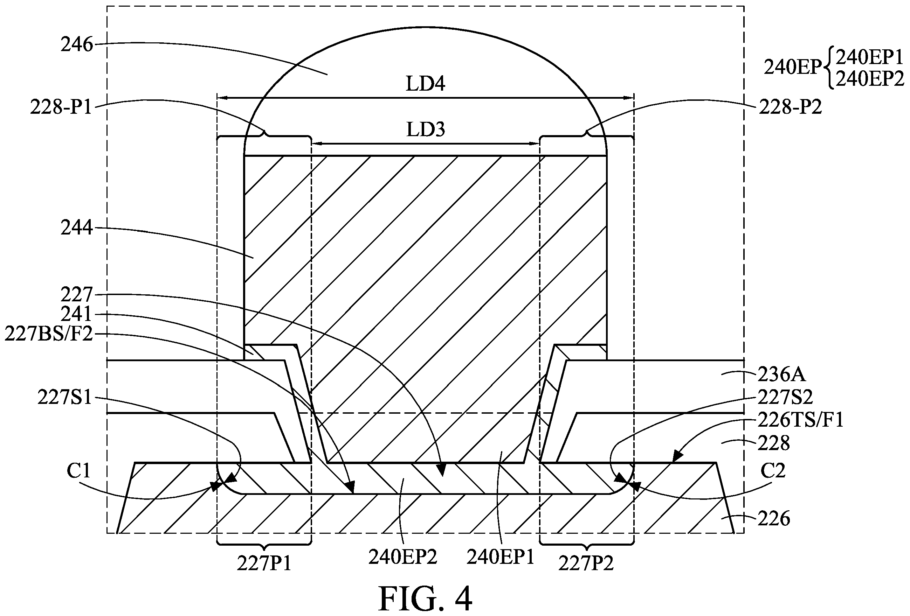

FIG. 3 is a schematic cross-sectional view of a semiconductor structure 500B in accordance with some embodiments of the disclosure. FIG. 4 is a partial enlarged view of FIG. 3. Elements of the embodiments hereinafter, that are the same or similar as those previously described with reference to FIGS. 1 and 2, are not repeated for brevity. As shown in FIGS. 3 and 4, the difference between the semiconductor structure 500A and the semiconductor structure 500B at least includes that the semiconductor structure 500B further includes a photosensitive stress buffer layer 236A. In some embodiments, the photosensitive stress buffer layer 236A is used for providing reliable insulation when the semiconductor device 250 is subjected to various types of environmental stress.

The photosensitive stress buffer layer 236A may be conformally formed on the second passivation layer 228. In some embodiments, the photosensitive stress buffer layer 236A may extend from the top surface 228TS of the second passivation layer 228 into the opening 230. More specifically, the photosensitive stress buffer layer 236A lines the opening 230. The photosensitive stress buffer layer 236A is in contact with the under bump metallurgy (UBM) layer 241. In addition, the sub-portion 240EP1 of the embedded portion 240EP of the conductive bump structure 240 is surrounded by the photosensitive stress buffer layer 236A. The second passivation layer 228 and the photosensitive stress buffer layer 236A may cover different portions of the sub-portion 240EP2 of the embedded portion 240EP of the conductive bump structure 240. As shown in FIG. 3, the conductive pillar 244 may be separated from the second passivation layer 228 by the photosensitive stress buffer layer 236A. In addition, the photosensitive stress buffer layer 236A is spaced apart from the conductive pad 226.

As shown in FIG. 3, the photosensitive stress buffer layer 236A has an opening 238A to expose the recess 227 of the conductive pad 226. In some embodiments, the opening 238A of the photosensitive stress buffer layer 236A is located within and aligned with the opening 230 of the second passivation layer 228. In the direction 100 substantially parallel to the top surface 226TS of the conductive pad 226, the dimension LD3 of the sub-portion 240EP1 may be equal to a dimension of the opening 238A and less than the dimension of the opening 230.

In some embodiments, the photosensitive stress buffer layer 236A may include polyimide or another applicable photosensitive material. In some embodiments, the photosensitive stress buffer layer 236A is formed by a coating process, a photolithography process and a subsequent a curing process. In this embodiment, the photosensitive stress buffer layer 236A of the semiconductor structure SOOB may have a PI (polyimide) pull-in structure because the photosensitive stress buffer layer 236A pulls in the opening 230 of the second passivation layer 228.

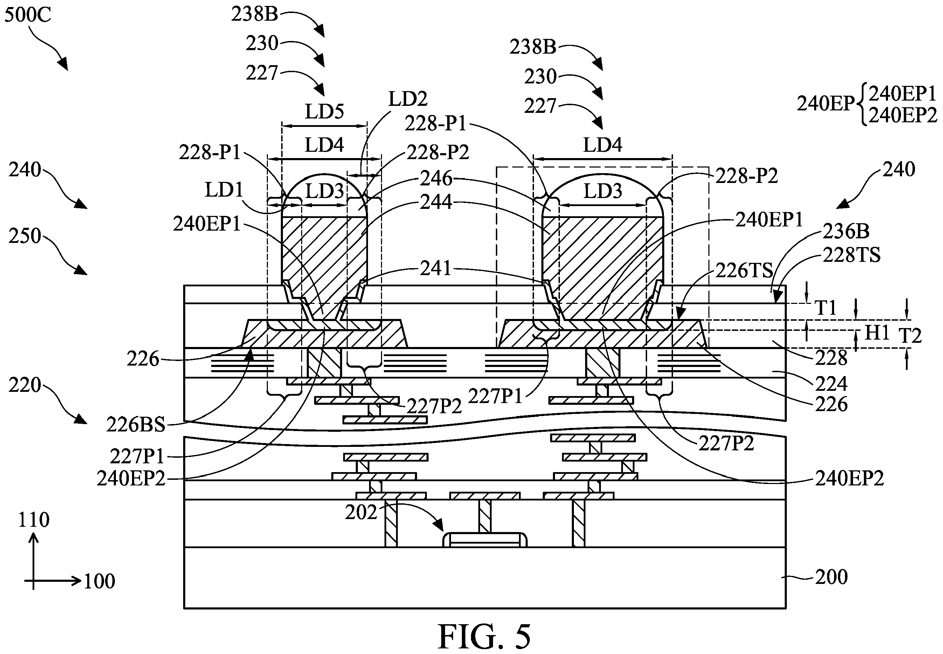

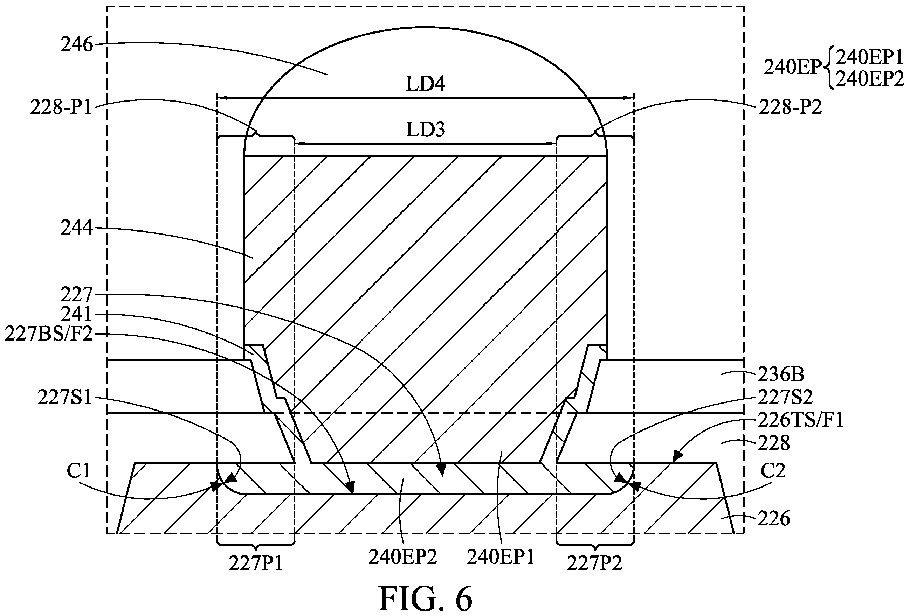

FIG. 5 is a schematic cross-sectional view of a semiconductor structure 500C in accordance with some embodiments of the disclosure. FIG. 6 is a partial enlarged view of FIG. 5. Elements of the embodiments hereinafter, that are the same or similar as those previously described with reference to FIGS. 1 to 4, are not repeated for brevity. As shown in FIGS. 5-6, the difference between the semiconductor structure 500B and the semiconductor structure 500C at least includes that the semiconductor structure 500C further includes a photosensitive stress buffer layer 236B.

In this embodiment, the photosensitive stress buffer layer 236B is located above the opening 230 of the second passivation layer 228. The conductive pillar 244 of the conductive bump structure 240 may be surrounded by the photosensitive stress buffer layer 236B. The photosensitive stress buffer layer 236B may not extend into the opening 230. More specifically, the photosensitive stress buffer layer 236B may be spaced apart from the opening 230 of the second passivation layer 228. In addition, the photosensitive stress buffer layer 236B is spaced apart from the conductive pad 226 and the embedded portion 240EP of the conductive bump structure 240. As shown in FIG. 5, a portion of the conductive bump structure 240 above the embedded portion 240EP may be in contact with the photosensitive stress buffer layer 236B and the second passivation layer 228.

As shown in FIG. 5, the photosensitive stress buffer layer 236B has an opening 238B to expose the recess 227 of the conductive pad 226 and in the opening 230 of the second passivation 228. In some embodiments, the opening 230 of the second passivation layer 228 is located within and aligned with the opening 238B of photosensitive stress buffer layer 236B in the direction 110 that is substantially perpendicular to the top surface 226TS of the conductive pad 226. In the direction 100 substantially parallel to the top surface 226TS of the conductive pad 226, a dimension of the opening 238B may be greater than the dimension LD3 of the sub-portion 240EP1 and less than the dimension LD5 of the portion of the conductive bump structure 240 protruding from the top surface 228TS of the second passivation layer 228.

In some embodiments, the processes and the materials for forming the photosensitive stress buffer layer 236A (FIG. 3) may be similar to, or the same as, those for forming the photosensitive stress buffer layer 236B. In this embodiment, the photosensitive stress buffer layer 236B of the semiconductor structure 500C may have a PI (polyimide) pull-out structure because the photosensitive stress buffer layer 236B pulls out the opening 230 of the second passivation layer 228.

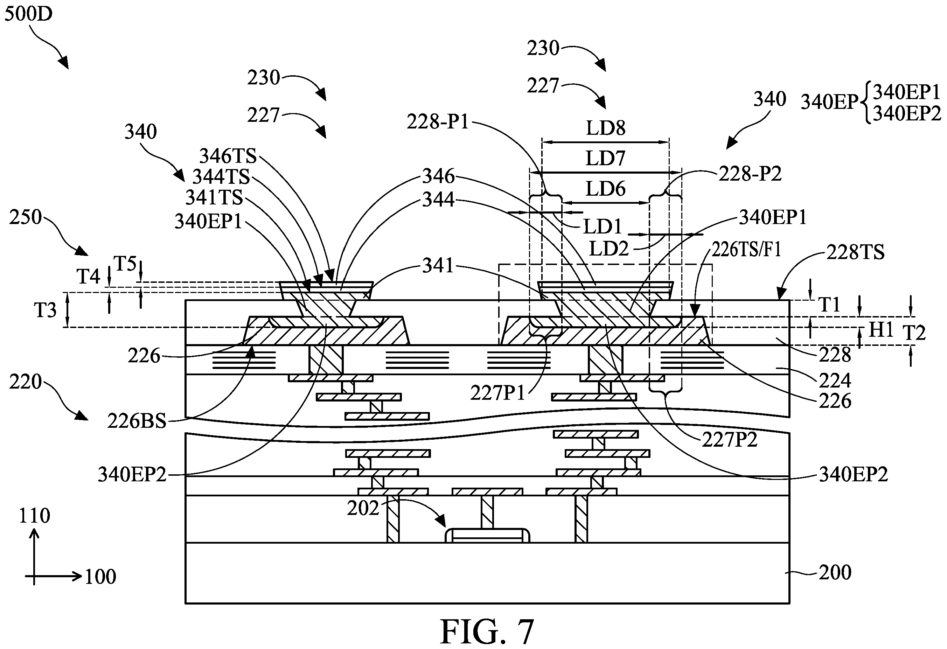

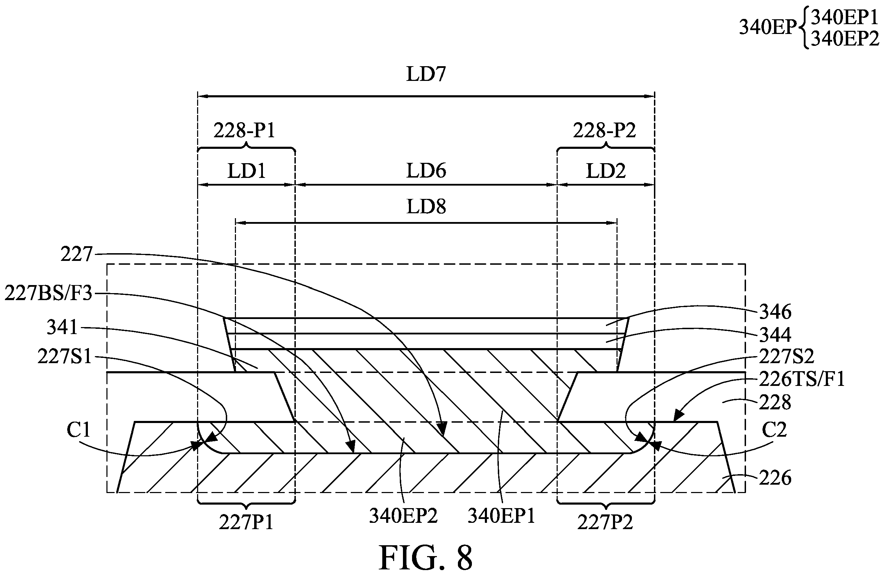

FIG. 7 is a schematic cross-sectional view of a semiconductor structure 500D in accordance with some embodiments of the disclosure. FIG. 8 is a partial enlarged view of FIG. 7. Elements of the embodiments hereinafter, that are the same or similar as those previously described with reference to FIGS. 1 to 6, are not repeated for brevity. As shown in FIGS. 7-8, the difference between the semiconductor structure 500A and the semiconductor structure 500D at least includes that semiconductor structure 500D uses a conductive bump structure 340 to replace the conductive bump structure 240 of the semiconductor structure SOOA.

In some embodiments, in the direction 100, an interface Fl between the second passivation layer 228 and the conductive pad 226 is located beside and misaligned with an interface F3 between the conductive bump structure 340 and the conductive pad 226. For example, the interface Fl may be located at the top surface 226TS of the conductive pad 226. In addition, the interface F3 may be located at the bottom surface 227BS of the recess 227 of the conductive pad 226.

As shown in FIG. 7, a distance between the interface Fl and the interface F3 in the direction 110 may be the same as the depth H1 of the recess 227. Therefore, in the direction 110, a ratio of the thickness T2 of the conductive pad 226 to the distance (H1) between the interface Fl and the interface F3 (i.e., T2/H1) may be between 1 and 75.

In some embodiments, the conductive bump structure 340 has an embedded portion 340EP embedding into the second passivation layer 228 and the conductive pad 226. In addition, the embedded portion 340EP may be adjacent to the protruding portions 228-P1 and 228-P2 of the second passivation layer 228. In some embodiments, the embedded portion 340EP of the conductive bump structure 340 has a pillar shape, an inverted hammer shape or an anchor-like shape. For example, as shown in FIG. 4, the embedded portion 340EP of the conductive bump structure 340 may have an inverted hammer shape or an anchor-like shape.

In some embodiments, the embedded portion 340EP of the conductive bump structure 240 includes sub-portions 340EP1 and 340EP2. The sub-portion 340EP1 may be formed embedded into the second passivation layer 228. The sub-portion 340EP2 may be formed embedded into the conductive pad 226. In the direction 100, the sub-portion 340EP1 may have a dimension LD6, the sub-portion 340EP2 may have a dimension LD7. In some embodiments, the dimension LD6 is equal to a dimension of the opening 230 of the second passivation layer 228. The dimension LD7 is greater than or equal to the dimension LD6. In addition, a portion of the conductive bump structure 340 protruding from the top surface 228TS of the second passivation layer 228 may have a dimension LD8 that is greater than or equal to the dimension LD6. In some embodiments, the sub-portion 340EP1 may serve as a narrow neck portion of the conductive bump structure 340.

As shown in FIG. 7, the conductive bump structure 340 such as an ENEPIG bump structure may include a base layer 341 located on the conductive pad 226, a buffer layer 344 located on the base layer 341 and a final outer layer 346 on the buffer layer 344.

As shown in FIG. 7, the base layer 341 is formed passing through the opening 230 of the second passivation layer 228 and filled the recess 227 of the conductive pad 226. The embedded portion 340EP of the conductive bump structure 340 is composed of the base layer 341. The base layer 341 may protrude from the top surface 228TS of the second passivation layer 228. In addition, a top surface 341TS of the base layer 341 is a flat surface.

As shown in FIG. 7, the buffer layer 344 is formed above the second passivation layer 228 and in contact with the top surface 341TS of the base layer 341. In the direction 110, a thickness T3 of the base layer 341 is greater than a thickness T4 of the buffer layer 344. A top surface 344TS of the buffer layer 344 is a flat surface.

As shown in FIG. 7, the final outer layer 346 is formed above the second passivation layer 228 and is in contact with the top surface 344TS of the buffer layer 344. In the direction 110, a thickness T3 of the base layer 341 is greater than a thickness T5 of the final outer layer 346. A top surface 346TS of the final outer layer 346 is a flat surface.

In some embodiments, the base layer 341, the buffer layer 344 and the final outer layer 346 are formed of different metal materials. For example, when the conductive bump structure 340 includes an ENEPIG bump structure, the base layer 341 is formed of electroless nickel (Ni), the buffer layer 344 is formed of electroless palladium (Pd), and the final outer layer 346 is formed of immersion gold (Au). The nickel base layer 341 may avoid the migration and diffusion between the conductive pad 226 formed of Cu and the final outer layer 346 formed of Au. The palladium buffer layer 344 may prevents the gold atoms of the final outer layer 346 from replacing the nickel atoms of the base layer 341. The gold final outer layer 346 may have a low contact resistance and a protection from friction and resistance to oxidation.

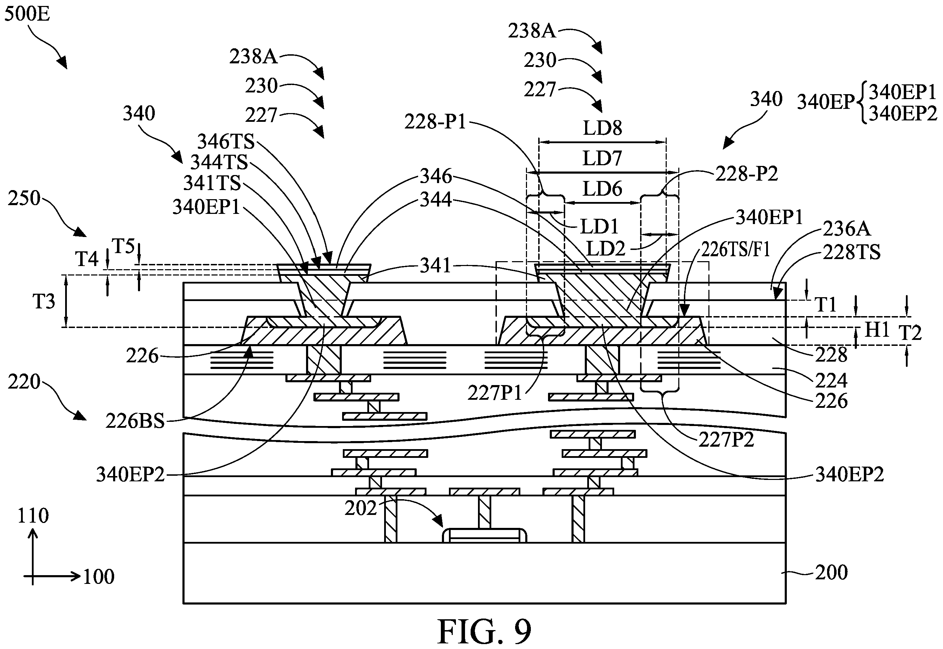

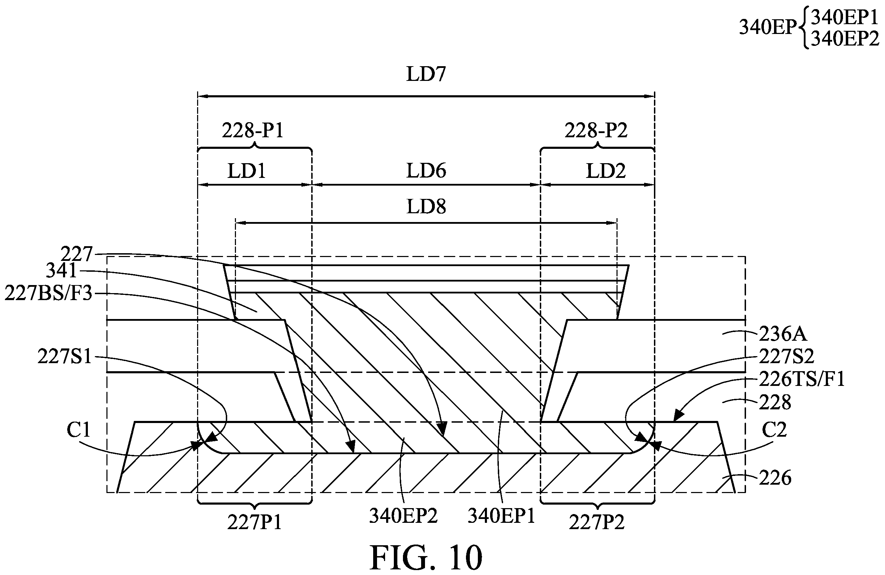

FIG. 9 is a schematic cross-sectional view of a semiconductor structure 500E in accordance with some embodiments of the disclosure. FIG. 10 is a partial enlarged view of FIG. 9. Elements of the embodiments hereinafter, that are the same or similar as those previously described with reference to FIGS. 1 to 8, are not repeated for brevity. As shown in FIGS. 9-10, the difference between the semiconductor structure 500D and the semiconductor structure 500E at least includes that the semiconductor structure 500E further includes the photosensitive stress buffer layer 236A. In some embodiments, the photosensitive stress buffer layers 236A of the semiconductor structures 500B and 500E may have the same or similar location, structure, materials and processes.

The photosensitive stress buffer layer 236A may be conformally formed on the second passivation layer 228. In some embodiments, the photosensitive stress buffer layer 236A may extend from the top surface 228TS of the second passivation layer 228 into the opening 230. More specifically, the photosensitive stress buffer layer 236A lines the opening 230. The photosensitive stress buffer layer 236A is in contact with the base layer 341. In addition, the sub-portion 340EP1 of the embedded portion 340EP of the conductive bump structure 340 is surrounded by the photosensitive stress buffer layer 236A. The photosensitive stress buffer layer 236A and the second passivation layer 228 may cover different portions of the sub-portion 340EP2 of the embedded portion 340EP of the conductive bump structure 340.

As shown in FIG. 9, the photosensitive stress buffer layer 236A has the opening 238A to expose the recess 227 of the conductive pad 226. In some embodiments, the opening 238A of the photosensitive stress buffer layer 236A is located within and aligned with the opening 230 of the second passivation layer 228. In the direction 100 substantially parallel to the top surface 226TS of the conductive pad 226, the dimension LD6 of the sub-portion 340EP1 may be equal to a dimension of the opening 238A and less than the dimension of the opening 230.

In this embodiment, the photosensitive stress buffer layer 236A of the semiconductor structure 500E may have a PI (polyimide) pull-in structure because the photosensitive stress buffer layer 236A pulls in the opening 230 of the second passivation layer 228.

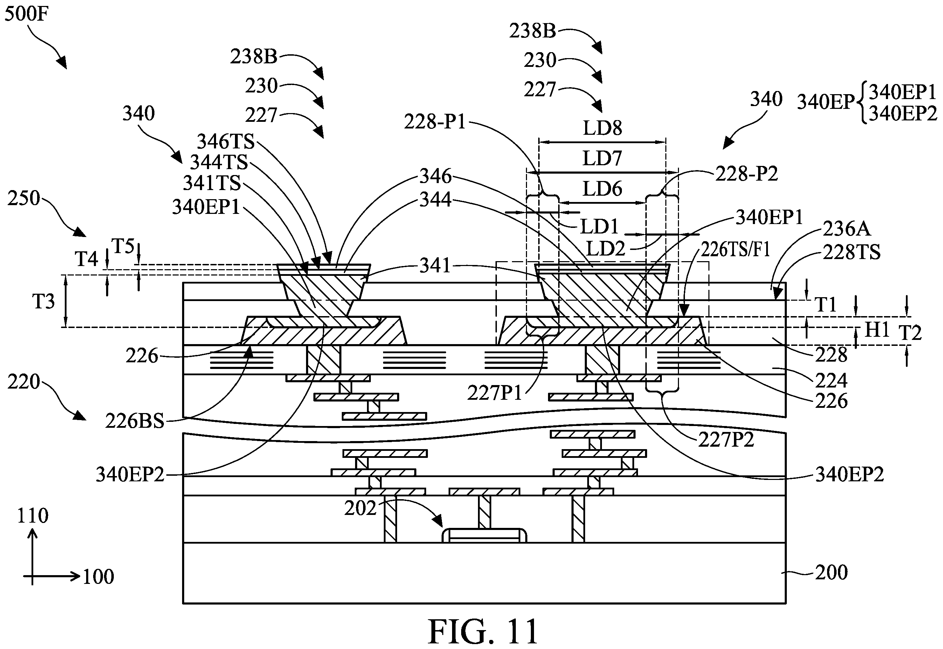

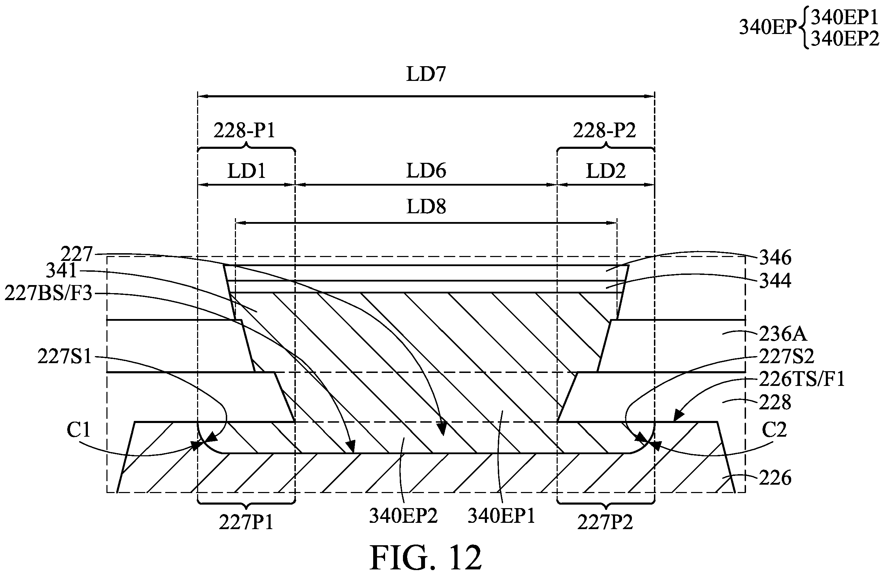

FIG. 11 is a schematic cross-sectional view of a semiconductor structure 500F in accordance with some embodiments of the disclosure. FIG. 12 is a partial enlarged view of FIG. 11. Elements of the embodiments hereinafter, that are the same or similar as those previously described with reference to FIGS. 1 to 10, are not repeated for brevity. As shown in FIGS. 11-12, the difference between the semiconductor structure 500E and the semiconductor structure 500F at least includes that the semiconductor structure SOOF further includes the photosensitive stress buffer layer 236B. In some embodiments, the photosensitive stress buffer layers 236A of the semiconductor structures 500C and 500F may have the same or similar location, structure, materials and processes.

In some embodiment, the photosensitive stress buffer layer 236B is located above the opening 230 of the second passivation layer 228. The base layer 241 of the conductive bump structure 340 may be surrounded by the photosensitive stress buffer layer 236B. The photosensitive stress buffer layer 236B may not extend into the opening 230. More specifically, the photosensitive stress buffer layer 236B may be spaced apart from the opening 230 of the second passivation layer 228. In addition, the photosensitive stress buffer layer 236B is spaced apart from the conductive pad 226 and the embedded portion 340EP of the conductive bump structure 340. As shown in FIG. 11, a portion of the conductive bump structure 340 above the embedded portion 340EP may be in contact with the photosensitive stress buffer layer 236B and the second passivation layer 228.

As shown in FIG. 11, the photosensitive stress buffer layer 236B has an opening 238B to expose the recess 227 of the conductive pad 226 and in the opening 230 of the second passivation 228. In some embodiments, the opening 230 of the second passivation layer 228 is located within and aligned with the opening 238B of photosensitive stress buffer layer 236B in the direction 110 that is substantially perpendicular to the top surface 226TS of the conductive pad 226. In the direction 100 substantially parallel to the top surface 226TS of the conductive pad 226, the dimension of the opening 238B may be greater than the dimension LD6 of the sub-portion 340EP1 and less than the dimension LD8 of the portion of the conductive bump structure 340 protruding from the top surface 228TS of the second passivation layer 228.

Since the conductive pad 236 of the semiconductor structures 500A to 500F has a unique recess 227. The subsequent conductive bump structure 240 (or the conductive bump structure 340) may have the embedded portion 240EP (or the embedded portion 340EP) further embedded into the conductive pad 226 to enhance the shear strength of the conductive bump structure 240 (or the conductive bump structure 340), thereby improving the reliability of the conductive bump structure240 (or the conductive bump structure 340).

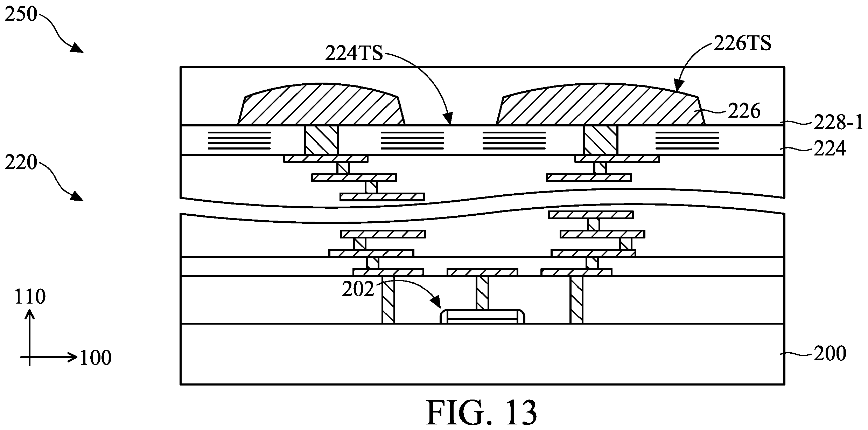

The method for forming the semiconductor structures 500A and 500D will be described below. FIGS. 13, 14, 15, 16, 17 and 18 are schematic cross-sectional views of intermediate stages of forming the semiconductor structure 500A of FIG. 1 (or the semiconductor structure 500D of FIG. 7) in accordance with some embodiments of the disclosure. Elements of the embodiments hereinafter, that are the same or similar as those previously described with reference to FIGS. 1 to 12, are not repeated for brevity.

Please refer to FIG. 13, the substrate 200 is provided. Next, the circuit element 202 is formed on the substrate 200. Next, the interconnect structure 220 is formed on the substrate 200 and the circuit element 202. The interconnect structure 220 may include the conductive pad 226 located at the top of the interconnect structure 220 and electrically connected to the circuit element 202. Therefore, the semiconductor device 250 is formed. As shown in FIG. 13, the top surface 226TS of the conductive pad 226 is a convex surface.

Next, a lower portion 228-1 of the second passivation layer 228 (FIG. 1) is entirely formed on the interconnect structure 220 by a deposition process. The lower portion 228-1 of the second passivation layer 228 (FIG. 1) may fully cover the top surface 226TS of the conductive pad 226 and a top surface 224TS of first passivation layer 224 exposed from the conductive pad 226.

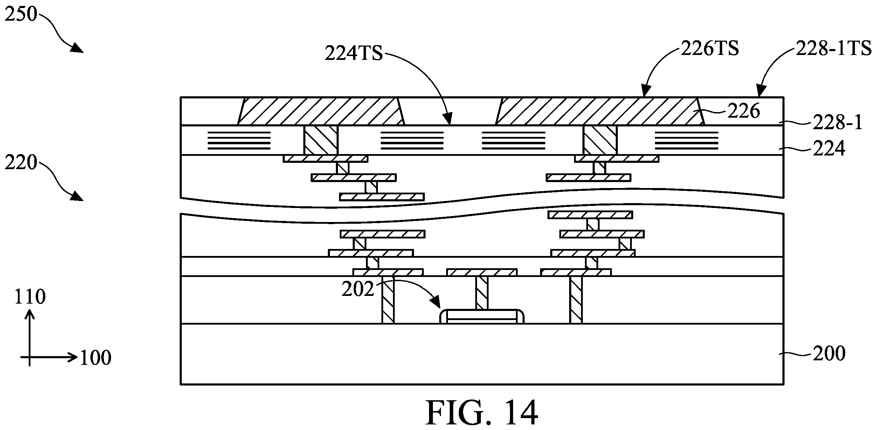

Please refer to FIG. 14, next, a planarization process is performed to remove a portion of the lower portion 228-1 of the second passivation layer 228 (FIG. 1) and a portion of the conductive pad 226 in order to planarize the tops of the lower portion 228-1 of the second passivation layer 228 (FIG. 1) and the conductive pad 226. As shown in FIG. 14, the top surface 226TS of the conductive pad 226 is a flat surface level with the top surface 228-1TS of the lower portion 228-1 of the second passivation layer 228 after the planarization process. More specifically, the top surface 226TS of the conductive pad 226 and the top surface 228-1TS of the lower portion 228-1 of the second passivation layer 228 are both flat surfaces that are level with each other after the planarization process. Therefore, the top surface (including the top surface 226TS of the conductive pad 226 and the top surface 228-1 TS of the lower portion 228-1 of the second passivation layer 228) of the intermediate semiconductor structure shown in FIG. 14 is a flat surface. In some embodiments, the planarization process includes chemical mechanical polishing (CMP).

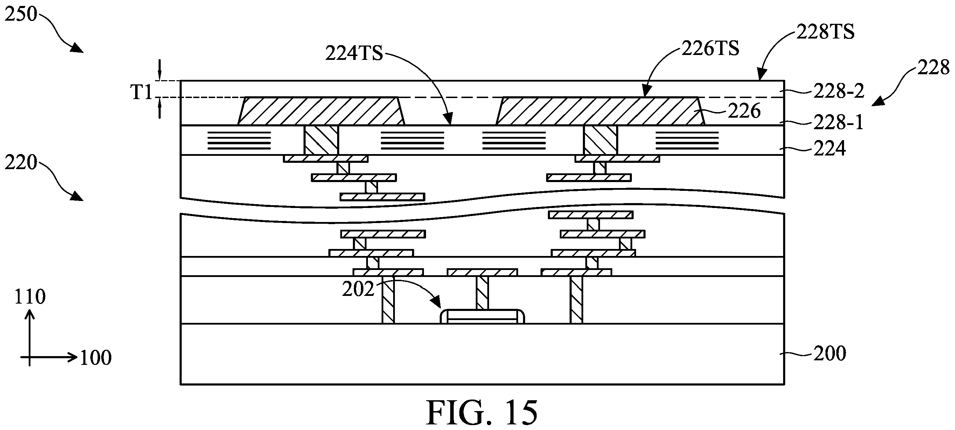

Please refer to FIG. 15, next, another deposition process is performed to form an upper portion 228-2 of the second passivation layer 228 covering the lower portion 228-1 of the second passivation layer 228 and the top surface 226TS of the conductive pad 226. Therefore, the second passivation layer 228 including the lower portion 228-1 and the upper portion 228-2 located on the lower portion 228-1 is formed on the interconnect structure 220. In addition, the top surface of the upper portion 228-2 of the second passivation layer 228 may serve as the top surface 228TS of the second passivation layer 228. In some embodiments, the thickness of the upper portion 228-2 of the second passivation layer 228 may serve as the thickness T1 of the second passivation layer 228 above the top surface 226TS of the conductive pad 226 and range between about 5 µm and 25 µm. Since the top surface of the intermediate semiconductor structure shown in FIG. 14 is a flat surface, the upper portion 228-2 of the second passivation layer 228 is formed to include a flat top surface after the deposition process. In some embodiments, the lower portion 228-1 and the upper portion 228-2 of the second passivation layer 228 may have the same or similar materials and fabrication processes. Therefore, the lower portion 228-1 and the upper portion 228-2 of the second passivation layer 228 may be formed as an integrated passivation layer without an interface therebetween.

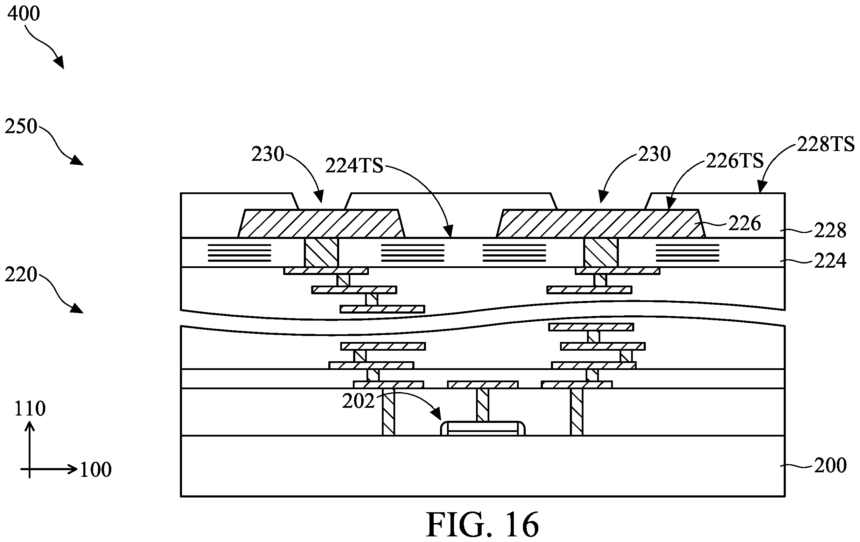

Please refer to FIG. 16, next, a patterning process is performed to from an opening 230 passing through the second passivation layer 228 above the conductive pad 226 (i.e., the upper portion 228-2 of the second passivation layer 228 shown in FIG. 15). The opening 230 is formed to expose a portion of the top surface 226TS of the conductive pad 226. In some embodiments, the patterning process includes a photolithography process and a subsequent anisotropic etching process such as dry etching.

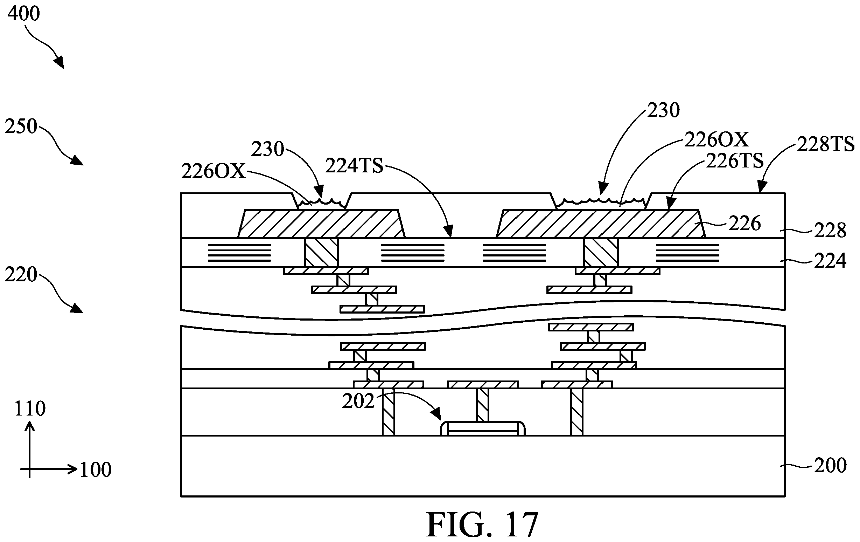

FIG. 17 illustrates the formation of oxides 226OX on the conductive pad 226. When the intermediate semiconductor structure 400 shown in FIG. 16 is in the long queue storage before performing the subsequent bumping process, a portion of the top surface 226TS of the conductive pad 226 exposed from the opening 230 may be oxidized to form the oxides 226OX.

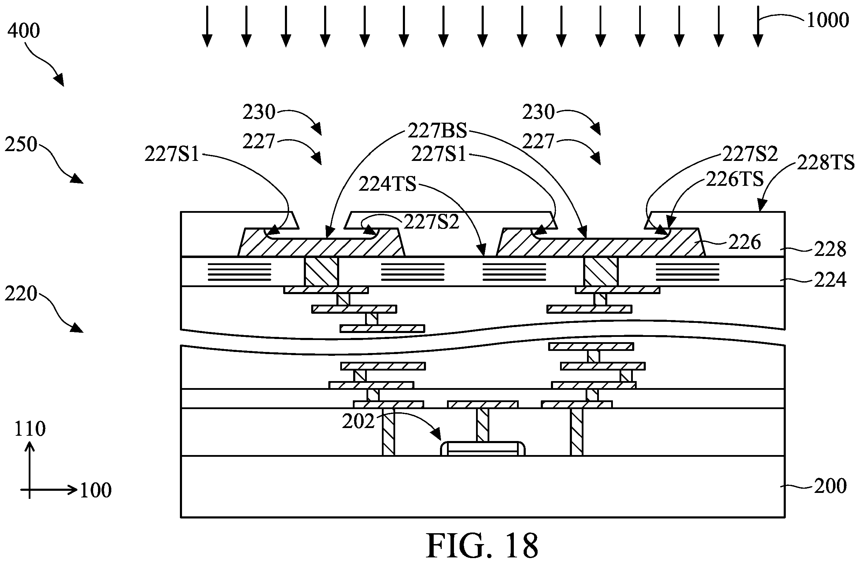

When the intermediate semiconductor structure 400 shown in FIG. 16 or FIG. 17 will be subjected the bumping process, a surface treatment process 1000 is performed on the conductive pad 226 exposed from the opening 230, as shown in FIG. 18. The surface treatment process 1000 may remove any possible oxides 226OX on the exposed conductive pad 226 shown in FIG. 17. In addition, the surface treatment process 1000 may further remove a portion of the exposed conductive pad 226 to form the recess 227 of the conductive pad 226. The recess 227 of the conductive pad 226 is recessed from the top surface 226TS of the conductive pad 226 exposed from the opening 230. In some embodiments, the opposite side surfaces 227S1 and 227S2 of the recess 227 may have a vertical profile, an overcut profile or an undercut profile. In this embodiments, the opposite side surfaces 227S1 and 227S2 of the recess 227 may have a vertical profile or an undercut profile. In some embodiments, the surface treatment process 1000 includes a physical surface treatment process or a chemical surface treatment process. For example, the physical surface treatment process may include dry etching. The chemical surface treatment process may include wet cleaning.

Please refer to FIG. 1, next, a bumping process is performed to form the conductive bump structure 240 on the second passivation layer 228. The conductive bump structure 240 is formed filling the opening 300 and the recess 227 of the conductive pad 226. In addition, the conductive bump structure 240 is connected to the conductive pad 226. In some embodiments, the bumping process includes blanket forming the under bump metallurgy (UBM) layer 241 on the second passivation layer 228 by a deposition method. The under bump metallurgy (UBM) layer 241 is formed lining the opening 230 and filling up the recess 227 of the conductive pad 226.

As shown in FIG. 1, next, the bumping process further includes entirely forming a photoresist layer (not shown) on the UBM layer 241. In some embodiments, the photoresist layer includes a dry film photoresist or a liquid photoresist. Next, the photoresist layer is patterned by a photolithography process comprising an exposure step and a development step to form an opening (not shown) over the conductive pad 226. In some embodiments, the opening defines define a diameter and shape of the subsequent conductive pillar 244.

As shown in FIG. 1, next, the bumping process further includes forming the conductive pillar 244 on a portion of the UBM layer 241 without covered by the photoresist layer pattern. The conductive pillar 244 is formed filling the opening 230 of the second passivation layer 228 and the opening of the photoresist layer and covering a portion of the UBM layer 241 by electroplating or electrochemical deposition (ECD). Therefore, the conductive pillar 244 is formed through the photoresist layer and electrically connected to the conductive pad 226 through the UBM layer 241. In some embodiments, the conductive pillar 244 and the seed layer (not shown) of the UBM layer 241 are formed of the same material, such as copper (Cu).

As shown in FIG. 1, next, the bumping process further includes forming the solder cap 246 on the conductive pillar 244 by a solder plating process, a photoresist stripping process, and a solder reflow process. After the solder cap 246 is formed, the conductive bump structure 240 is formed. Accordingly, the semiconductor structure 500A in accordance with some embodiments of the disclosure is formed.

Alternatively, after performing the surface treatment process 1000 (FIG. 18) on the intermediate semiconductor structure 400 shown in FIG. 16 or FIG. 17, another bumping process may be performed to form the conductive bump structure 340 (e.g., the ENEPIG bump structure) on the second passivation layer 228, as shown in FIG. 7. The conductive bump structure 340 is formed filling the opening 300 and the recess 227 of the conductive pad 226. In addition, the conductive bump structure 340 is connected to the conductive pad 226.

In some embodiments, the bumping process includes depositing the base layer 341 on the second passivation layer 228 by an electroless plating method. The base layer 341 is formed filling up the opening 230 and the recess 227 of the conductive pad 226.

As shown in FIG. 3, next, the bumping process further includes depositing the buffer layer 344 on the base layer 341 by an electroless plating method. Next, the bumping process further includes depositing the final outer layer 346 on the buffer layer 344 by an electroless plating method. After the final outer layer 346 is formed, the conductive bump structure 340 is formed. Accordingly, the semiconductor structure 500B in accordance with some embodiments of the disclosure is formed.

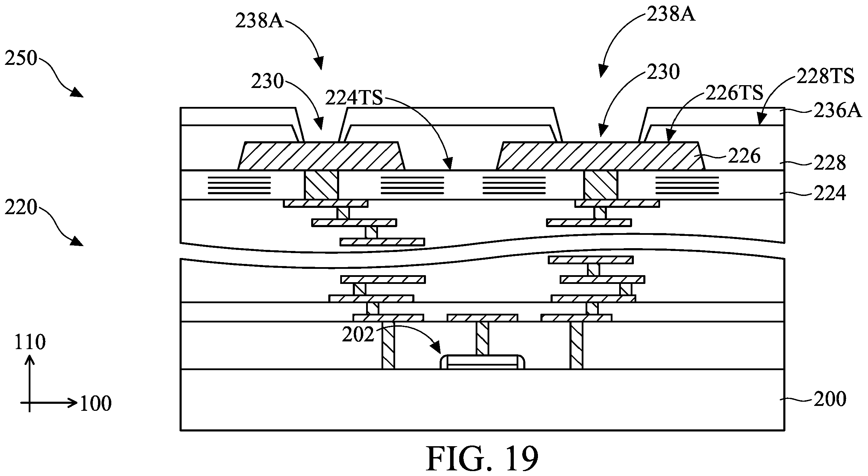

FIG. 19 is a schematic cross-sectional view of an intermediate stage of forming the semiconductor structure 500B of FIG. 3 (or the semiconductor structure 500E of FIG. 9) in accordance with some embodiments of the disclosure. Elements of the embodiments hereinafter, that are the same or similar as those previously described with reference to FIGS. 1 to 18, are not repeated for brevity.

When the intermediate semiconductor structure 400 shown in FIG. 16 or FIG. 17 will be subjected the surface treatment process 1000 shown in FIG. 18, a coating process is performed to conformally forming the photosensitive stress buffer material layer 236A on the second passivation layer 228, as shown in FIG. 19. The photosensitive stress buffer layer 236A may cover the top surface 228TS of the second passivation layer 228 and line the opening 230 of the second passivation layer 228. Furthermore, the photosensitive stress buffer layer 236A may cover the top surface 226TS of the conductive pad 226 exposed from the opening 230 of the second passivation layer 228 (FIG. 16 or FIG. 17).

Next, a photolithography process including an exposure step and a development step is performed to form the opening 238A passing through the photosensitive stress buffer layer 236A to expose the portion of the conductive pad 226. The photosensitive stress buffer layer 236A is subjected to the photolithography process to remove a portion of the photosensitive stress buffer layer 236A directly on the portion of the conductive pad 226 in the opening 230 to form the opening 238A. The remaining photosensitive stress buffer layer 236A may cover the top surface 228TS of the second passivation layer 228 and line the opening 230 of the second passivation layer 228.

Next, the photosensitive stress buffer layer 236A having the opening 238A is subjected to a curing process to solidify the photosensitive stress buffer layer 236A. After the curing process, the level of the photosensitive stress buffer layer 236A may drop as a result of shrinkage of the photosensitive stress buffer layer.

Next, the surface treatment process 1000 as shown in FIG. 18 is performed to form the recess 227 of the conductive pad 226, as shown in FIG. 3 (or FIG. 9).

Next, as shown in FIG. 3 (or FIG. 9), the bumping process similar to those described referring to FIG. 1 (or FIG. 7) is performed to form the conductive bump structure 240 (or the conductive bump structure 340) on the second passivation layer 228 and the photosensitive stress buffer layer 236A. In addition, the conductive bump structure 240 (or the conductive bump structure 340) is formed passing through the openings 230 and 238A and connected to the conductive pad 226. After the aforementioned processes have been performed, the semiconductor structure 500B in accordance with some embodiments of the disclosure as shown in FIG. 3 (or the semiconductor structure 500D in accordance with some embodiments of the disclosure as shown in FIG. 9) is formed.

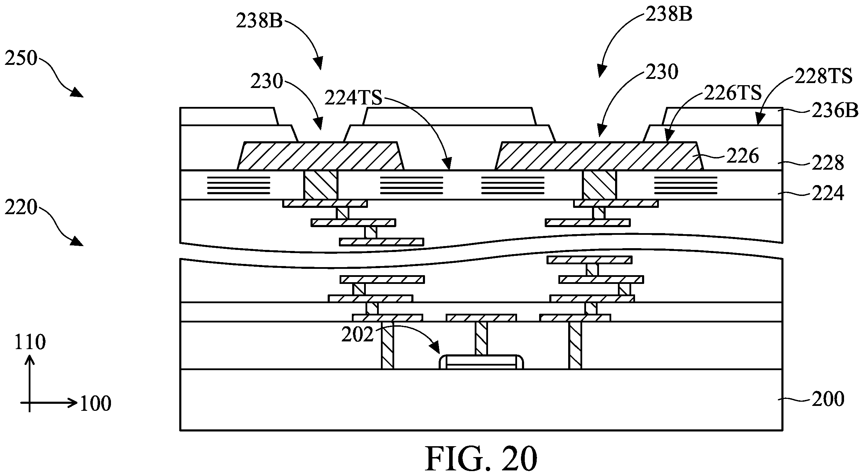

FIG. 20 is a schematic cross-sectional view of an intermediate stage of forming the semiconductor structure 500C of FIG. 5 (or the semiconductor structure 500F of FIG. 11) in accordance with some embodiments of the disclosure. Elements of the embodiments hereinafter, that are the same or similar as those previously described with reference to FIGS. 1 to 19, are not repeated for brevity.

When the intermediate semiconductor structure 400 shown in FIG. 16 or FIG. 17 will be subjected the surface treatment process 1000 shown in FIG. 18, a coating process is performed to conformally forming the photosensitive stress buffer layer 236B on the second passivation layer 228, as shown in FIG. 20. The photosensitive stress buffer layer 236B may cover the top surface 228TS of the second passivation layer 228 and line the opening 230 of the second passivation layer 228. Furthermore, the photosensitive stress buffer layer 236B may cover the top surface 226TS of the conductive pad 226 exposed from the opening 230 of the second passivation layer 228 (FIG. 16 or FIG. 17).

Next, a patterning process (including a photolithography process including an exposure step and a development step) is performed to form the opening 238B passing through the photosensitive stress buffer layer 236B to expose the portion of the conductive pad 226 in the opening 230 and a portion of the second passivation layer 228 in the opening 238B. A portion of the photosensitive stress buffer layer 236B lining the opening 230 of the second passivation layer 228 and directly on the portion of the conductive pad 226 in the opening 230 are removed to form the opening 238B by the photolithography process.

Next, the surface treatment process 1000 as shown in FIG. 18 is performed to form the recess 227 of the conductive pad 226, as shown in FIG. 5 (or FIG. 11).

Next, as shown in FIG. 5 (or FIG. 11), the bumping process similar to those described referring to FIG. 1 (or FIG. 7) is performed to form the conductive bump structure 240 (or the conductive bump structure 340) on the second passivation layer 228 and the photosensitive stress buffer layer 236B. In addition, the conductive bump structure 240 (or the conductive bump structure 340) is formed passing through the openings 230 and 238B and connected to the conductive pad 226. After the aforementioned processes have been performed, the semiconductor structure 500C in accordance with some embodiments of the disclosure as shown in FIG. 5 (or the semiconductor structure 500F in accordance with some embodiments of the disclosure as shown in FIG. 11) is formed.

Embodiments provide a semiconductor structure. The semiconductor structure in accordance with some embodiments of the disclosure includes an interconnect structure, the topmost passivation layer, and a conductive bump structure. The conductive bump structure is disposed on and embedded into the topmost passivation layer and the conductive pad. In the first direction, which is substantially parallel to the top surface of the conductive pad, the first interface between the topmost passivation layer and the conductive pad is located beside and misaligned with the second interface between the conductive bump structure and the conductive pad.

When the intermediate semiconductor structure will be subjected the bumping process after the long queue storage, a surface treatment process may be performed on the exposed conductive pad formed of copper. The surface treatment process including dry etching (physical) or wet cleaning (chemical) may remove any possible oxides on the exposed conductive pad. The surface treatment process may further remove a portion of the exposed conductive pad to form an evitable and irregular recess of the conductive pad recessed from the top surface of the conductive pad exposed from the opening of the topmost passivation layer.

In some embodiments, in the second direction, which is substantially perpendicular to the top surface of the conductive pad, the ratio of the first thickness of the conductive pad to the first distance between the first interface and the second interface is between 1 and 75.

In some embodiments, the recess of the conductive pad has a first bottom surface, a first side surface and a second side surface. The first bottom surface is surrounded by the first top surface. The first and second side surfaces are opposite each other and connected between the first top surface of the conductive pad and the first bottom surface of the recess. In some embodiments, the. first interface is located between the passivation layer and the first top surface of the conductive pad, and the second interface is located between the conductive bump structure and the first bottom surface of the recess of the conductive pad In some embodiments, the conductive bump structure is in contact with the first bottom surface, the first side surface and the second side surface of the recess. In some embodiments, the first bottom surface of the recess comprises a flat surface or a concave surface. In some embodiments, a first corner between the first side surface and the first bottom surface of the recess comprises a sharp corner or a rounded corner.

In some embodiments, the passivation layer includes a first protruding portion and a second protruding portion facing each other. The first protruding portion is formed protruding from the first top surface and positioned over the first side surface and the first bottom surface in the first direction. The second protruding portion is formed protruding from the first top surface and positioned over the second side surface and the first bottom surface of the recess in the first direction.

In some embodiments, the embedded portion is adjacent to the first protruding portion and the second protruding portion. In some embodiments, in the first direction, a third dimension of the first protruding portion and a fourth dimension of the second protruding portion are between 0.01 µm and 3 µm. In some embodiments, the ratio of the third dimension to the fourth dimension is between 0.03 and 3.

In some embodiments, the opposite first and second side surfaces of the recess may have a vertical profile or an undercut profile underneath the topmost passivation layer and/or the photosensitive stress buffer layer. In some embodiments, the first extending portion, the first side surface and a portion of the first bottom surface overlapping the first extending portion form a lateral portion of the recess. In some embodiments, the conductive bump structure fills the lateral portion of the recess. In some embodiments, the lateral portion of the recess has a rounded shape, a polygonal shape, a scallop shape, a strip shape, or an irregular shape.

In some embodiments, the embedded portion of the subsequent formed conductive bump structure may be formed corresponding to the shape of the recess and have a pillar shape, an inverted hammer shape or an anchor-like shape. The inverted hammer shaped or anchor-like shaped conductive bump structure may be formed corresponding to the recess having the lateral portion. In some embodiments, the embedded portion of the conductive bump structure includes a first sub-portion embedded into the passivation layer and a second sub-portion embedded into the conductive pad. The first sub-portion has a first dimension in the first direction. The second sub-portion has a second dimension that is greater than or equal to the first dimension.

In some embodiments, the conductive bump structure such as a microbump, a copper pillar bump or a controlled collapse chip connection (C4) bump includes an under bump metallurgy (UBM) layer located on the conductive pad, a conductive pillar located on the under bump metallurgy layer, and a solder cap located on the conductive pillar. The embedded portion includes the under bump metallurgy layer and the conductive pillar. In some embodiments, the first sub-portion is formed of the under bump metallurgy layer and the conductive pillar, and the second sub-portion is formed of the under bump metallurgy layer.

In some embodiments, the conductive bump structure such as an ENEPIG bump structure includes a base layer located on the conductive pad, a buffer layer located on the base layer, and a final outer layer located on the buffer layer. In some embodiments, the base layer protrudes from the top surface of the passivation layer.

In some embodiments, the semiconductor structure further includes a photosensitive stress buffer layer conformally formed on the passivation layer. The conductive bump structure is surrounded by the photosensitive stress buffer layer. In some embodiments, the photosensitive stress buffer layer is located above the embedded portion of the conductive bump structure. In some embodiments, the photosensitive stress buffer layer extends into the passivation layer and surrounds the embedded portion of the conductive bump structure.

Since the surface treatment process is required to be performed on the exposed conductive pad applied in the copper RDL scheme, a unique recess of the conductive pad will be accordingly created. The subsequent conductive bump structure may have the embedded portion further embedded into the conductive pad to enhance the shear strength of the conductive bump structure, thereby improving the reliability of the conductive bump structure.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses:
1. A semiconductor structure, comprising: an interconnect structure comprising a conductive pad located at a top of the interconnect structure; a passivation layer disposed on the interconnect structure; and a conductive bump structure disposed on and embedded into the passivation layer and the conductive pad, wherein in a first direction, a first interface between the passivation layer and the conductive pad is located beside and misaligned with a second interface between the conductive bump structure and the conductive pad.
2. The semiconductor structure of clause 1, wherein in a second direction, a ratio of a first thickness of the conductive pad to a first distance between the first interface and the second interface is between 1 and 75.
3. The semiconductor structure of clause 1, wherein an embedded portion of the conductive bump structure embedded into the passivation layer and the conductive pad has a pillar shape, an inverted hammer shape or an anchor-like shape.
4. The semiconductor structure of clause 3, wherein the embedded portion of the conductive bump structure comprises: a first sub-portion embedded into the passivation layer, wherein the first sub-portion has a first dimension in the first direction; and a second sub-portion embedded into the conductive pad, wherein the second sub-portion has a second dimension that is greater than or equal to the first dimension.
5. The semiconductor structure of clause 1, wherein the conductive pad comprises: a recess recessed from a first top surface of the conductive pad, wherein the recess has a first bottom surface, a first side surface and a second side surface, the first bottom surface is surrounded by the first top surface, and the first and second side surfaces are connected between the first top surface of the conductive pad and the first bottom surface of the recess.
6. The semiconductor structure of clause 5, wherein the first interface is located at the first top surface of the conductive pad, and the second interface is located at the first bottom surface of the recess of the conductive pad.
7. The semiconductor structure of clause 5, wherein the conductive bump structure is in contact with the first bottom surface, the first side surface and the second side surface of the recess.
8. The semiconductor of clause 5, wherein the first bottom surface of the recess comprises a flat surface or a concave surface.
9. The semiconductor structure of clause 1, wherein a first corner between the first side surface and the first bottom surface of the recess comprises a sharp corner or a rounded corner.
10. The semiconductor structure of clause 3, wherein the passivation layer comprises: a first protruding portion protruding from the first top surface and positioned over the first side surface and the first bottom surface along the first direction; and a second protruding portion protruding from the first top surface and positioned over the second side surface and the first bottom surface of the recess along the first direction.
11. The semiconductor structure of clause 10, wherein the embedded portion is adjacent to the first protruding portion and the second protruding portion.
12. The semiconductor structure of clause 10, wherein in the first direction, a third dimension of the first protruding portion and a fourth dimension of the second protruding portion are between 0.01 µm and 3 µm.
13. The semiconductor structure of clause 12, wherein a ratio of the third dimension to the fourth dimension is between 0.03 and 3.
14. The semiconductor structure of clause 10, wherein the first extending portion, the first side surface and a portion of the first bottom surface overlapping the first extending portion form a lateral portion of the recess.
15. The semiconductor structure of clause 14, wherein the conductive bump structure fills the lateral portion of the recess.
16. The semiconductor structure of clause 14, wherein the lateral portion of the recess has a rounded shape, a polygonal shape, a scallop shape, a strip shape, or an irregular shape.
17. The semiconductor structure of clause 4, wherein the conductive bump structure comprises: an under bump metallurgy (UBM) layer located on the conductive pad; a conductive pillar located on the under bump metallurgy layer; and a solder cap located on the conductive pillar, wherein the embedded portion comprises the under bump metallurgy layer and the conductive pillar.
18. The semiconductor structure of clause 17, wherein the first sub-portion is formed of the under bump metallurgy layer and the conductive pillar, and the second sub-portion is formed of the under bump metallurgy layer.
19. The semiconductor structure of clause 3, wherein the conductive bump structure comprises: a base layer located on the conductive pad; a buffer layer located on the base layer; and a final outer layer located on the buffer layer, wherein the base layer, the buffer layer and the final outer layer are formed of different metal materials, and the embedded portion is composed of the base layer.
20. The semiconductor structure of clause 19, wherein the base layer protrudes from a top surface of the passivation layer.
21. The semiconductor structure of clause 3, further comprising; a photosensitive stress buffer layer conformally formed on the passivation layer, wherein the conductive bump structure is surrounded by the photosensitive stress buffer layer.
22. The semiconductor structure of clause 21, wherein the photosensitive stress buffer layer is located above the embedded portion of the conductive bump structure.
23. The semiconductor structure of clause 21, wherein the photosensitive stress buffer layer extends into the passivation layer and surrounds the embedded portion of the conductive bump structure.
24. A method for forming a semiconductor structure, comprising: forming an interconnect structure comprising a conductive pad located at a top of the interconnect structure; forming a passivation layer on the interconnect structure; forming a first opening passing through the passivation layer to expose a top surface of the conductive pad; performing a surface treatment process to form a recess of the conductive pad recessed from the top surface of the conductive pad exposed from the first opening; and forming a conductive bump structure on the passivation layer, filling the first opening and the recess of the conductive pad, wherein in a first direction, a first interface between the passivation layer and the conductive pad is located beside and misaligned with a second interface between the conductive bump structure and the conductive pad.
25. The method for forming a semiconductor structure of clause 24, wherein opposite side surfaces of the recess have a vertical profile, an overcut profile or an undercut profile.
26. The method for forming a semiconductor structure of clause 24, wherein forming the conductive bump structure comprises: forming an under bump metallurgy (UBM) layer lining the first opening and filling the recess of the conductive pad; forming a conductive pillar on the under bump metallurgy layer and filling the first opening; and forming a solder cap located on the conductive pillar.
27. The method for forming a semiconductor structure of clause 24, wherein forming the conductive bump structure comprises: depositing a base layer filling the first opening and the recess of the conductive pad, wherein the base layer protrudes from a top surface of the passivation layer; depositing a buffer layer on the base layer; and depositing a final outer layer on the buffer layer.
28. The method for forming a semiconductor structure of clause 24, further comprising: conformally forming a photosensitive stress buffer layer on the passivation layer before forming the conductive bump structure; and forming a second opening passing through the photosensitive stress buffer layer to expose the portion of the conductive pad.
29. The method for forming a semiconductor structure of clause 28, further comprising: performing a photolithography process to remove a portion of the photosensitive stress buffer layer directly on the portion of the conductive pad in the first opening to form the second opening.
30. The method for forming a semiconductor structure of clause 28, further comprising: performing a photolithography process to remove a portion of the photosensitive stress buffer layer lining the passivation layer in the first opening and directly on the portion of the conductive pad in the first opening to form the second opening.

## Claims

1. A semiconductor structure (500A, 500B, 500C, 500D, 500E, 500F), comprising:
an interconnect structure (250) comprising a conductive pad (226) located at a top of the interconnect structure (250);
a passivation layer (228) disposed on the interconnect structure (250); and
a conductive bump structure (240, 340) disposed on and embedded into the passivation layer (228) and the conductive pad (226), wherein in a first direction (100), a first interface (F1) between the passivation layer (228) and the conductive pad (226) is located beside and misaligned with a second interface (F2) between the conductive bump structure (240, 340) and the conductive pad (226).

2. The semiconductor structure (500A, 500B, 500C, 500D, 500E, 500F) as claimed in claim 1, wherein in a second direction (110), a ratio of a first thickness (T2) of the conductive pad (226) to a first distance (H1) between the first interface (F 1) and the second interface (F2) is between 1 and 75.

3. The semiconductor structure (500A, 500B, 500C, 500D, 500E, 500F) as claimed in claim 1, wherein an embedded portion (240EP, 340EP) of the conductive bump structure (240, 340) embedded into the passivation layer (228) and the conductive pad (226) has a pillar shape, an inverted hammer shape or an anchor-like shape.

4. The semiconductor structure (500A, 500B, 500C, 500D, 500E, 500F) as claimed in claim 3, wherein the embedded portion (240EP, 340EP) of the conductive bump structure (240, 340) comprises:
a first sub-portion (240EP1, 340EP1) embedded into the passivation layer (228), wherein the first sub-portion (240EP1, 340EP1) has a first dimension (LD3, LD6) in the first direction (100); and
a second sub-portion (240EP2, 340EP2) embedded into the conductive pad (226), wherein the second sub-portion (240EP2, 340EP2) has a second dimension (LD4, LD7) that is greater than or equal to the first dimension (LD3, LD6).

5. The semiconductor structure (500A, 500B, 500C, 500D, 500E, 500F) as claimed in claim 1, wherein the conductive pad (226) comprises:
a recess (227) recessed from a first top surface (226TS) of the conductive pad (226), wherein the recess (227) has a first bottom surface (227BS), a first side surface (227S1) and a second side surface (227S2), the first bottom surface (227BS) is surrounded by the first top surface (226TS), and the first and second side surfaces (227S1, 227S2) are connected between the first top surface (226TS) of the conductive pad (226) and the first bottom surface (227BS) of the recess (227).

6. The semiconductor structure (500A, 500B, 500C, 500D, 500E, 500F) as claimed in claim 5, wherein the first interface (F1) is located at the first top surface (226TS) of the conductive pad (226), and the second interface (F2) is located at the first bottom surface (227BS) of the recess (227) of the conductive pad (226); and/or
wherein the conductive bump structure (240, 340) is in contact with the first bottom surface (227BS), the first side surface (227S1) and the second side surface (227S2) of the recess (227); and/or
wherein the first bottom surface (227BS) of the recess (227) comprises a flat surface or a concave surface; and/or
wherein a first corner (C1) between the first side surface (227S1) and the first bottom surface (227BS) of the recess (227) comprises a sharp corner or a rounded corner.

7. The semiconductor structure (500A, 500B, 500C, 500D, 500E, 500F) as claimed in claim 3, wherein the passivation layer (228) comprises:
a first protruding portion (228-P1) protruding from the first top surface (226TS) and positioned over the first side surface (227S1) and the first bottom surface (227BS) along the first direction (100); and
a second protruding portion (228-P2) protruding from the first top surface (226TS) and positioned over the second side surface (227S1) and the first bottom surface (227BS) of the recess (227) along the first direction (100).

8. The semiconductor structure (500A, 500B, 500C, 500D, 500E, 500F) as claimed in claim 7, wherein the embedded portion (240EP, 340EP) is adjacent to the first protruding portion (228-P1) and the second protruding portion (228-P2); and/or
wherein in the first direction (100), a third dimension (LD1) of the first protruding portion (228-P1) and a fourth dimension (LD2) of the second protruding portion (228-P2) are between 0.01 µm and 3 µm, optionally wherein a ratio of the third dimension (LD1) to the fourth dimension (LD4) is between 0.03 and 3.

9. The semiconductor structure (500A, 500B, 500C, 500D, 500E, 500F) as claimed in claim 7, wherein the first protruding portion (228-P1), the first side surface (227S1) and a portion of the first bottom surface (227BS) overlapping the first protruding portion (228-P1) form a lateral portion (227P1) of the recess (227),
optionally wherein the conductive bump structure (240, 340) fills the first lateral portion (227P1) of the recess (227), and/or
optionally wherein the first lateral portion (227P1) of the recess (227) has a rounded shape, a polygonal shape, a scallop shape, a strip shape, or an irregular shape.

10. The semiconductor structure (500A, 500B, 500C, 500D, 500E, 500F) as claimed in claim 4, wherein the conductive bump structure (240, 340) comprises:
an under bump metallurgy, UBM, layer (241) located on the conductive pad (226);
a conductive pillar (244) located on the under bump metallurgy layer (241); and
a solder cap (246) located on the conductive pillar (244), wherein the embedded portion (240EP, 340EP) comprises the under bump metallurgy layer (241) and the conductive pillar (244);
optionally wherein the first sub-portion (240EP1, 340EP1) is formed of the under bump metallurgy layer (241) and the conductive pillar (244), and the second sub-portion (240EP2, 340EP2) is formed of the under bump metallurgy layer (241).

11. The semiconductor structure (500A, 500B, 500C, 500D, 500E, 500F) as claimed in claim 3, wherein the conductive bump structure (240, 340) comprises:
a base layer (241, 341) located on the conductive pad (226);
a buffer layer (344) located on the base layer (241, 341); and
a final outer layer (346) located on the buffer layer (344), wherein the base layer (241, 341), the buffer layer (344) and the final outer layer (346) are formed of different metal materials, and the embedded portion (240EP, 340EP) is composed of the base layer (241, 341);
optionally wherein the base layer (241, 341) protrudes from a top surface (228TS) of the passivation layer (228).

12. The semiconductor structure (500A, 500B, 500C, 500D, 500E, 500F) as claimed in claim 3, further comprising;
a photosensitive stress buffer layer (236A) conformally formed on the passivation layer (228), wherein the conductive bump structure (240, 340) is surrounded by the photosensitive stress buffer layer (236A);
optionally wherein the photosensitive stress buffer layer (236A) is located above the embedded portion (240EP, 340EP) of the conductive bump structure (240, 340); and/or
optionally wherein the photosensitive stress buffer layer (236A) extends into the passivation layer (228) and surrounds the embedded portion (240EP, 340EP) of the conductive bump structure (240, 340).

13. A method for forming a semiconductor structure (500A, 500B, 500C, 500D, 500E, 500F), comprising:
forming an interconnect structure (250) comprising a conductive pad (226) located at a top of the interconnect structure (250);
forming a passivation layer (228) on the interconnect structure (250);
forming a first opening (230) passing through the passivation layer (228) to expose a top surface (226TS) of the conductive pad (226);
performing a surface treatment process to form a recess (227) of the conductive pad (226) recessed from the top surface (226TS) of the conductive pad (226) exposed from the first opening (230); and
forming a conductive bump structure (240, 340) on the passivation layer (228), filling the first opening (230) and the recess (227) of the conductive pad (226), wherein in a first direction (100), a first interface (F1) between the passivation layer (228) and the conductive pad (226) is located beside and misaligned with a second interface (F2) between the conductive bump structure (240, 340) and the conductive pad (226).

14. The method for forming a semiconductor structure (500A, 500B, 500C, 500D, 500E, 500F) as claimed in claim 13, wherein opposite side surfaces (227S1, 227S2) of the recess (227) have a vertical profile, an overcut profile or an undercut profile; and/or
wherein forming the conductive bump structure (240, 340) comprises: forming an under bump metallurgy, UBM, layer (241) lining the first opening (230) and filling the recess (227) of the conductive pad (226); forming a conductive pillar (244) on the under bump metallurgy layer (241) and filling the first opening (230); and forming a solder cap (246) located on the conductive pillar (244); and/or
wherein forming the conductive bump structure (240, 340) comprises: depositing a base layer (241, 341) filling the first opening (230) and the recess (227) of the conductive pad (226), wherein the base layer (241, 341) protrudes from a top surface (228TS) of the passivation layer (228); depositing a buffer layer (344) on the base layer (241, 341); and depositing a final outer layer (346) on the buffer layer (344).

15. The method for forming a semiconductor structure (500A, 500B, 500C, 500D, 500E, 500F) as claimed in claim 13, further comprising: conformally forming a photosensitive stress buffer layer (236A) on the passivation layer (228) before forming the conductive bump structure (240, 340); and forming a second opening (238B) passing through the photosensitive stress buffer layer (236A) to expose the portion of the conductive pad (226);
optionally further comprising: performing a photolithography process to remove a portion of the photosensitive stress buffer layer (236A) directly on the portion of the conductive pad (226) in the first opening (230) to form the second opening (238B); and/or
optionally further comprising: performing a photolithography process to remove a portion of the photosensitive stress buffer layer (236A) lining the passivation layer (228) in the first opening (230) and directly on the portion of the conductive pad (226) in the first opening (230) to form the second opening (238B).
